**Europäisches Patentamt**

**European Patent Office**

**Office européen des brevets**

(19)

(11) Veröffentlichungsnummer: **0 259 825 B1**

(12) # EUROPÄISCHE PATENTSCHRIFT

(45) Veröffentlichungstag der Patentschrift: **04.12.91**

(51) Int. Cl.⁵: **C23C 8/68**, C21D 9/00

(21) Anmeldenummer: **87113086.0**

(22) Anmeldetag: **08.09.87**

(54) **Verfahren zum Randschichthärten von Werkstücken und Vorrichtung zur Durchführung des Verfahrens.**

(30) Priorität: **08.09.86 DE 3630487**

(43) Veröffentlichungstag der Anmeldung:
**16.03.88 Patentblatt 88/11**

(45) Bekanntmachung des Hinweises auf die
Patenterteilung:
**04.12.91 Patentblatt 91/49**

(84) Benannte Vertragsstaaten:
**AT BE CH DE ES FR GB IT LI NL SE**

(56) Entgegenhaltungen:
**EP-A- 0 175 157**
**EP-A- 0 181 653**
**US-A- 3 019 126**

(73) Patentinhaber: **Elektroschmelzwerk Kempten GmbH**
**Herzog-Wilhelm-Strasse 16**
**W-8000 München 2(DE)**

(72) Erfinder: **Fichtl, Walter, Dr. Dipl.-Ing.**
**Schiefbahner Strasse 63**
**W-4044 Kaarst 2(DE)**

## Beschreibung

Es ist bekannt, Werkstücke aus Metallen oder Metallegierungen einer thermochemischen Behandlung zu unterziehen, um Randschichten von hoher Härte und damit verschleißfeste Oberflächenschichten zu erzeugen. So können beispielsweise Eisenwerkstoffe Aufkohlungs-, Nitrier- oder Carbonitrierverfahren unterzogen werden, oder sie können durch Borieren oder durch Eindiffundieren von metallischen Elementen mit verschleißfesten Oberflächenschichten versehen werden. Derartige Behandlungen können mit festen, flüssigen oder gasförmigen Behandlungsmitteln vorgenommen werden. Gute Ergebnisse werden im allgemeinen durch Einsatz von festen Behandlungsmitteln in Pulverform erzielt, die unter dem Begriff "Pulverpackverfahren" literaturbekannt sind (vgl. Ullmanns Enzyklopädie der technischen Chemie, 4. Auflage 1978, Band 16, Seite 537-545).

Bekannt ist ebenfalls, derartige feste Behandlungsmittel in der Wirbelschicht anzuwenden, die in einem Reaktionsbehälter durch Gasverteilung erzeugt wird. Die zu behandelnden Werkstücke werden dabei zweckmäßig mittels einer Halte- oder Aufhängevorrichtung in die Wirbelschicht eingetaucht und für eine bestimmte Zeit bei bestimmter Temperatur mit dem Behandlungsmittel kontaktiert. Auf diese Weise können Werkstoffe von einfacher oder komplizierter Form auf ihrer gesamten Oberfläche thermochemisch behandelt werden (vgl. US-A-3 053 704, US-A-3 405 000). Besonders bewährt hat sich diese Behandlungsmethode in der Wirbelschicht zum Borieren der Oberflächen von Metallen oder Metallegierungen, bei welcher das feste Boriermittel in Form eines Granulats aus nahezu kugelförmigen Teilchen eingesetzt wird (vgl. EP-A-175 157).

Mit Hilfe der Wirbelschichttechnik, bei der die zu behandelnden Werkstücke im Inneren eines Reaktionsbehälters stationär angeordnet sind und jeweils vollständig in die Wirbelschicht eintauchen, können im allgemeinen nur relativ kleine Werkstükke auf ihrer gesamten Oberfläche thermochemisch behandelt werden. Für ein partielles Randschichthärten, worunter die thermochemische Behandlung von Teilbereichen der Werkstückoberfläche zu verstehen ist, ist die Wirbelschichttechnik indessen nicht geeignet, weil ein einfaches Abdecken der Oberflächenbereiche, die von der Behandlung ausgeschlossen sein sollen, wie bei dem bekannten Pulverpackverfahren, wegen der Bettbewegung in der Wirbelschicht und der dadurch bedingten Erosionsgefahr praktisch unmöglich ist. So können beispielsweise Rohre, die nur an der Rohrinnenseite oder nur an der Rohraußenseite mit einer verschleißfesten Oberflächenschicht versehen werden sollen, nicht durch Eintauchen in die Wirbelschicht einer thermochemischen Behandlung unterzogen werden. Haben solche Rohre mehrere Meter Länge, dann sind zudem die wirtschaftlich arbeitenden Öfen zu klein, um diese aufzunehmen. Das gleiche gilt auch für massive strangförmige Körper, die auch ein dünnes, drahtförmiges Material sein können.

Aus der US-A-3,019,126 ist zwar bereits eine Vorrichtung bekannt, womit Stahldrähte oder -bänder in der Wirbelschicht mit beispielsweise Kunststoffen oder Magnesiumoxid beschichtet werden können. Der Draht wird durch eine poröse Platte in die Wirbelschicht eingeführt, die vorteilhaft durch Zufuhr eines brennbaren Gasgemisches aus dem Beschichtungsmaterial erzeugt und direkt beheizt wird. Die Haftung der Beschichtungsteilchen auf dem Draht kann außer durch diese thermische Abscheidungsmethode auch durch elektrostatische Abscheidungsmethoden erreicht werden. Derartige Abscheidungsmethoden sind jedoch für Borierverfahren ungeeignet.

Es stellt sich somit die Aufgabe, das Verfahren zum Borieren von Werkstücken aus Metallen oder Metallegierungen durch thermochemisches Behandeln mittels fester Boriermittel in der Wirbelschicht, die durch Verteilung eines Fluidisierungsgases in einem Reaktionsofen mit Hilfe eines Anströmbodens erzeugt wird, so zu verbessern, daß hiermit lange Werkstücke ganz oder teilweise boriert werden können.

Diese Aufgabe wird erfindungsgemäß dadurch gelöst, daß lange rohrförmige oder strangförmige Werkstücke um mindestens einen ortsfesten Anströmboden herum und durch Öffnungen in demselben geführt, mit ihrer zu behandelnden Oberfläche senkrecht in Richtung der Längsachse des Ofens von unten nach oben durch die Wirbelschicht, die über mindestens einem ortsfesten Anströmboden erzeugt wird, bewegt und dabei boriert werden.

Unter dem Ausdruck "lange rohrförmige oder strangförmige Werkstücke" sind solche zu verstehen, deren Länge die Höhe eines herkömmlichen Reaktionsofens mit der darin erzeugten Wirbelschicht erheblich übersteigt, oder anders ausgedrückt: Werkstücke, die länger sind als der Ofen selbst.

Der Grundgedanke für das erfindungsgemäße Verfahren besteht darin, das Werkstück durch die Wirbelschicht zu bewegen. Damit die thermochemische Behandlung über die ganze Länge des Werkstückes gleichmäßig vorgenommen werden kann, ist die senkrecht in einer Richtung zur Längsachse des Ofens, d.h. von unten nach oben, gleichmäßig erfolgende Bewegung des Werkstückes innerhalb der Wirbelschicht gegenüber dem ortsfesten Anströmboden vorgesehen.

Die Ausführungsformen für die Durchführung des erfindungsgemäßen Verfahrens können dabei vorteilhaft jeweils der Form des zu behandelnden Werkstückes angeglichen werden. So können beispielsweise rohrförmige Werkstücke nur auf der Rohrinnenseite oder nur auf der Rohraußenseite oder sowohl auf ihrer Innen- als auch auf ihrer Außenseite dem Borieren durch thermochemische Behandlung unterzogen werden. Hierbei besteht die Möglichkeit, das Werkstück selbst als Reaktionsbehälter bzw. als Reaktionsbehälterwandung zu nutzen und das Problem der Wärmeübertragung durch Außenheizung über die Behälterwand oder Wandung auf die Wirbelschicht zu lösen, um auf diese Weise die für das Borierverfahren notwendige Temperatur zu erreichen.

Als rohrförmige Werkstücke, die unter diesen Bedingungen dem Borieren auf ihrer Innenseite und/oder Außenseite unterzogen werden können, sind solche besonders geeignet, die über die ganze Länge einen gleichen Durchmesser bzw. gleiche lichte Weite aufweisen, wie Rohre mit kreisförmigem oder mehreckigem Querschnitt, z.B. Rund-, Mehrkant- oder Profilrohre.

So können beispielsweise lange Rohre mit kreisförmigem, mehreckigem oder profiliertem Querschnitt um einen ortsfesten Anströmboden herum und/oder durch eine Öffnung in demselben geführt und mit ihrer zu behandelnden Rohrinnen- und/oder Rohraußenoberfläche senkrecht in Richtung der Längsachse des Ofens von unten nach oben durch die Wirbelschicht transportiert werden.

Der Anströmboden, dessen Abmessungen dem Querschnitt des rohrförmigen Werkstückes entsprechen, wird bei Arbeitsbeginn in Bezug auf die Wärmequelle für die Außenheizung, die vorteilhaft ein Vertikalofen ist, ortsfest fixiert, mit der Gaszuführung für die Erzeugung der Wirbelschicht im Inneren und/oder am Äußeren des Werkstückes verbunden und gegen das beweglich angeordnete Werkstück gleitend abgedichtet. Nach Erzeugen der Wirbelschicht aus der für eine Behandlung benötigten Chargenmenge des festen Boriermittels durch die Gasverteilung über dem Anströmboden unter Aufheizen des Vertikalrohrofens, wird das zu borierende Werkstück langsam durch die Heizzone oberhalb des Anströmbodens, entsprechend der benötigten Behandlungszeit in axialer Richtung bewegt. Für eine halbkontinuierliche Arbeitsweise ist außerdem die Verwendung von Adaptern mit gleichen Durchmessern wie die rohrförmigen Werkstücke am oberen und unteren Ende zur Führung der zu behandelnden Werkstücke vorgesehen. Bei einem vollkontinuierlichen Betrieb sind keine Adapter erforderlich.

In gleicher Weise wie rohrförmige Werkstücke können auch strangförmige Werkstücke, wie lange massive Stäbe mit kreisförmigem, mehreckigem oder profiliertem Querschnitt durch mindestens eine Öffnung in einem ortsfesten Anströmboden geführt und mit ihrer zu borierenden Staboberfläche senkrecht in Richtung der Längsachse des Ofens von unten nach oben durch die Wirbelschicht transportiert werden.

Außerdem können lange dünne Drähte in mehreren Strängen durch einen ortsfesten Anströmboden, der mit dem Drahtdurchmesser entsprechenden Bohrungen versehen ist, geführt, mit ihrer zu borierenden Drahtoberfläche senkrecht in Richtung der Längsachse des Ofens von unten nach oben durch die Wirbelschicht bewegt und von Rolle zu Rolle verarbeitet werden.

Die Erfindung wird anhand der Zeichnungen wie folgt beschrieben. Es zeigen:

Figur 1      eine erste Ausführungsform zur Durchführung des erfindungsgemäßen Verfahrens für das Borieren der Innenwandung rohrförmiger Werkstücke im diskontinuierlichen Betrieb unter Verwendung von Adaptern oder aber geeignet für kontinuierlichen Betrieb, wobei anstatt der Adapter ebenfalls Werkstücke benutzt werden.

Figur 2      zeigt eine weitere Ausführungsform zur Durchführung des erfindungsgemäßen Verfahrens, welches hier ähnlich nach Figur 1 aufgebaut ist, jedoch für die Außenbehandlung rohrförmiger Werkstücke geeignet ist.

Figur 3      zeigt eine weitere Ausführungsform zur Durchführung des erfindungsgemäßen Verfahrens, wobei die Ausführungsformen nach Figuren 1 und 2 miteinander kombiniert werden, um rohrförmige Werkstücke auf ihrer Innen- und Außenseite gleichzeitig diskontinuierlich oder kontinuierlich zu borieren.

Figur 4      zeigt schematisch die Durchführung des Verfahrens am Beispiel der Ausführungsform nach Figur 1, nämlich diskontinuierlich unter Verwendung von Adaptern.

Figuren 5 - 8      zeigen Verbindungsmöglichkeiten von Werkstücken zueinander bzw. Verbindungsmöglichkeiten von Werkstücken mit Adaptern, wobei die Figur 5 eine Gewindeverbindung zeigt, die Figur 6 eine zylindrische Haftsitzverbindung, die Figur 7 eine konische, lose Verbindungsanordnung und die Figur 8 eine Schweißverbindung, welche vor Einschub in den Ofen erstellt wird und nach der Behandlung wieder aufgetrennt werden kann.

Figur 9     zeigt eine weitere Ausführungsform zur Durchführung des erfindungsgemäßen Verfahrens zur Außenbehandlung massiver strangförmiger Körper.

Figur 10     zeigt einen Rohrofen, der beispielsweise zum Borieren von dünnem, drahtförmigem Material geeignet ist und

Figur 11     zeigt Figur 10 in Aufsicht.

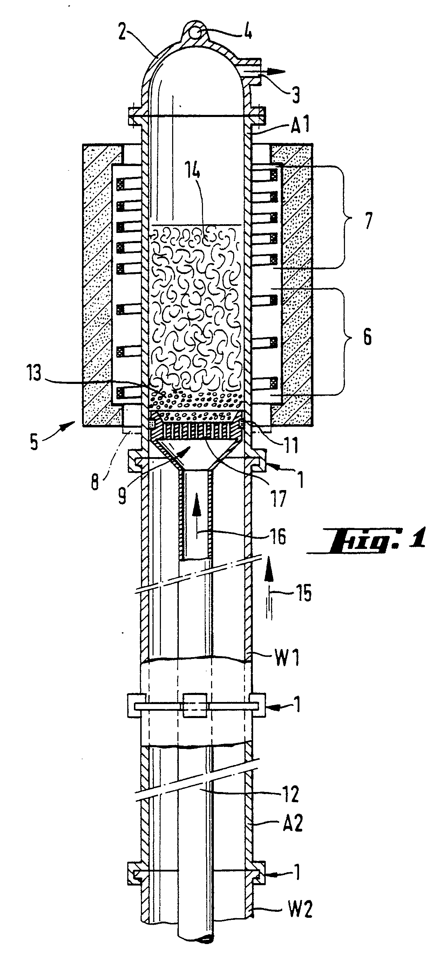

Die Ausführungsform nach Figur 1 zeigt zwei rohrförmige Werkstücke W1 und W2 mit anschließenden bzw. dazwischengeschalteten Adaptern A1 und A2. Werkstücke und Adapter sind mit Schnellschlußverbindungen 1 in Bajonettart verbunden. Oberhalb des oberen Adapters A1 ist eine Abzugsglocke 2 mit Abzug 3 und Transportöse 4 vorgesehen. Der ortsfeste Rohrofen 5 weist eine Vorwärmzone 6 und eine Heizzone 7 auf. Bei 8 ist eine Wärmeschleuse angedeutet.

Im Inneren der Adapter A bzw. Werkstücke W bzw. des Rohrofens 5 ist ortsfest ein Anströmboden 9 angeordnet, welcher eine hitzebeständige Gleitringdichtung 11 aufweist. Die ortsfeste Anordnung dieses Anströmbodens 9 samt seiner Düsenplatte 17 geschieht über eine ortsfeste Gaszuführung 12.

Auf dem Anströmboden 9 befindet sich eine grobe Bodenfüllung 13 z.B. aus SiC und darüber das feste Behandlungsgranulat 14, aus welchem die Wirbelschicht erzeugt wird.

Bei Arbeitsbeginn wird entsprechend Figur 1 die montierte Einheit aus Adaptern und Werkstücken mit dem Adapter A1 voran durch die Vorwärmzone 6 in Pfeilrichtung 15 geschoben. Das Fluidisierungsgas wird in Pfeilrichtung 16 durch die Düsenplatte 17 des Anströmbodens 9 eingeblasen und die Wirbelschicht aus dem Behandlungsgranulat 14 erzeugt.

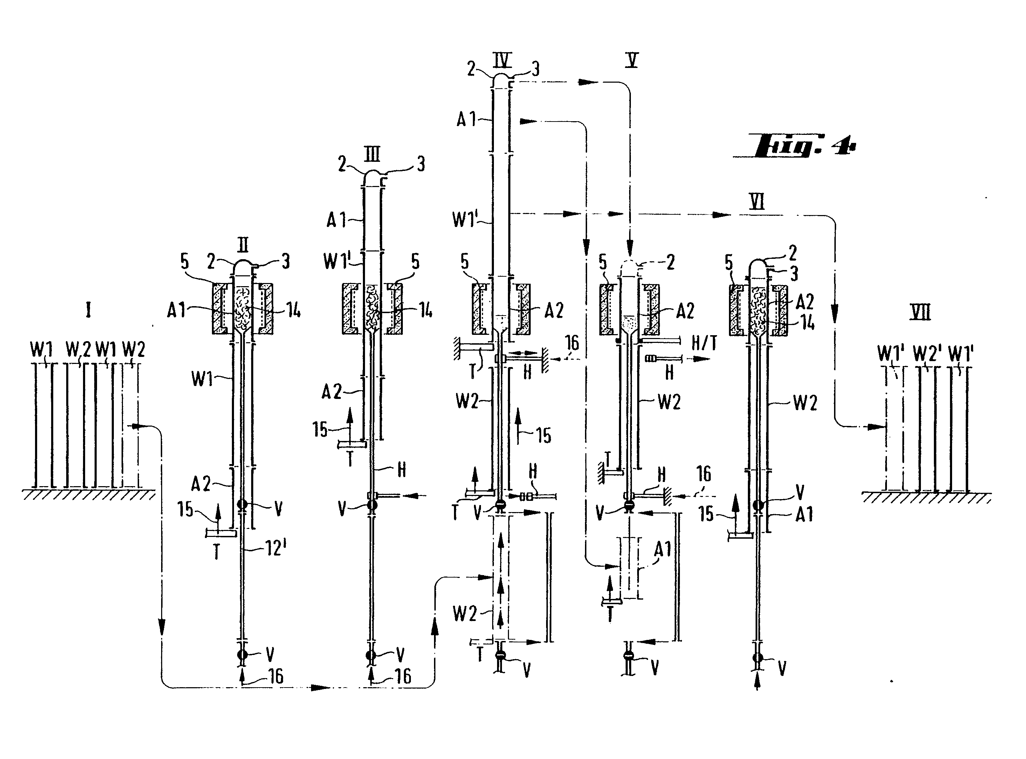

Das Niveau der Düsenplatte 17 bleibt während des Vorschubvorganges unverändert fest fixiert, siehe hierzu Station II - VI der Figur 4.

Hat nun gemäß Station IV der Figur 4 das nunmehr behandelte Werkstück W1' den Rohrofen 5 passiert, kommt die Anordnung zum Stillstand, wobei sich der untere Adapter A2 nunmehr im Rohrofen 5 befindet. Nun kann gemäß Station V der Figur 4 die Abzugsglocke 2, der Adapter A1 und das Werkstück W1' abgenommen werden. Die

Abzugsglocke wird dann auf den Adapter A2 aufgesetzt, während das behandelte Werkstück W1' bei VII abgesetzt wird. Der Adapter A1 indessen wird unter das nachfolgende Werkstück W2 montiert und es kann entsprechend Station VI der Figur 4 der Behandlungsvorgang des nächsten Werkstükkes beginnen.

Diese Methode mit Adaptern ist diskontinuierlich. Fügt man nun statt Adapter A Werkstücke ein und benützt im wechselhaften Betrieb Transporteinrichtungen T, Halteeinrichtungen H und Ventile V, dann ist ein vollkontinuierlicher Betrieb, wie die schematische Darstellung nach Figur 4 zeigt, ohne weiteres möglich. Dabei wird ein Stück 12' der Gaszuführung 12, nachdem die Ventile V auf Sperrstellung gestellt wurden, entnommen und ein weiteres Werkstück W2 von unten über die Gaszuführung 12 geschoben (Station IV der Figur 4). Währenddessen wird über Haltevorrichtung H die Gaszuführung 12 einerseits gehalten, andererseits durch die Haltevorrichtungen hindurch das Fließbett weiterhin mit Gas versorgt, um das Fließbett bei 14 arbeitsfähig aufrechtzuerhalten.

Es ist selbstverständlich, daß bei den Auswechselvorgängen der Werkstücke beim vollkontinuierlichen Verfahren die Transporteinrichtungen T und Halteeinrichtungen H axial stets mitbewegt werden.

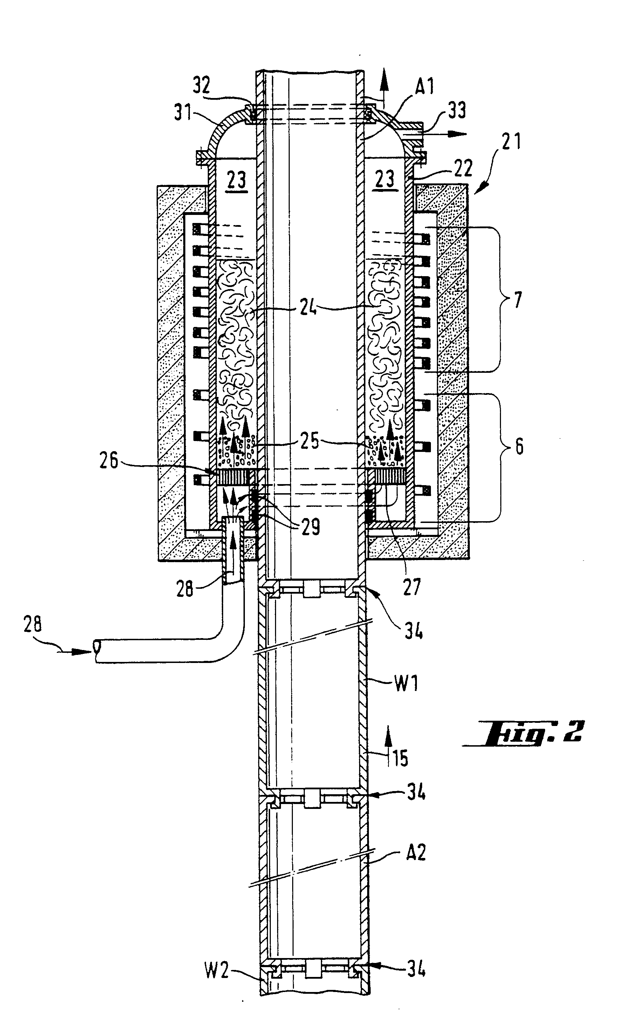

Gemäß Figur 2 ist es möglich, auch lediglich die Außenwandschicht der rohrförmigen Werkstücke W zu behandeln.

Hierzu ist der Rohrofen 21 mit einem Mantel 22 versehen, welcher größer als der Durchmesser des Werkstückes W bzw. der Adapter A ist. Im Ringraum 23 ist das Wirbelbett 24 und die grobe Bodenfüllung 25 über einem ringförmigen Anströmboden 26 angeordnet. Dieser beinhaltet eine kreisringförmige Düsenplatte 27, welche in Richtung der Pfeile 28 vom Fluidisierungsgas durchströmt wird. Ein oder mehrere Gleitringdichtungen 29 sorgen für die Abdichtung des Anströmbodens 26 zu den Werkstücken bzw. Adaptern.

Mit 31 ist die Abzugsglocke, mit 32 die Dichtung und mit 33 der Abzug bezeichnet.

Zwischen Adaptern und Werkstücken sind wieder Schnellverschlüsse 34 vorgesehen, welche nunmehr nach innen gerichtet und bajonettartig arbeitend ausgeführt sind. Es sind aber selbstverständlich auch andere Schnellverschlüsse denkbar.

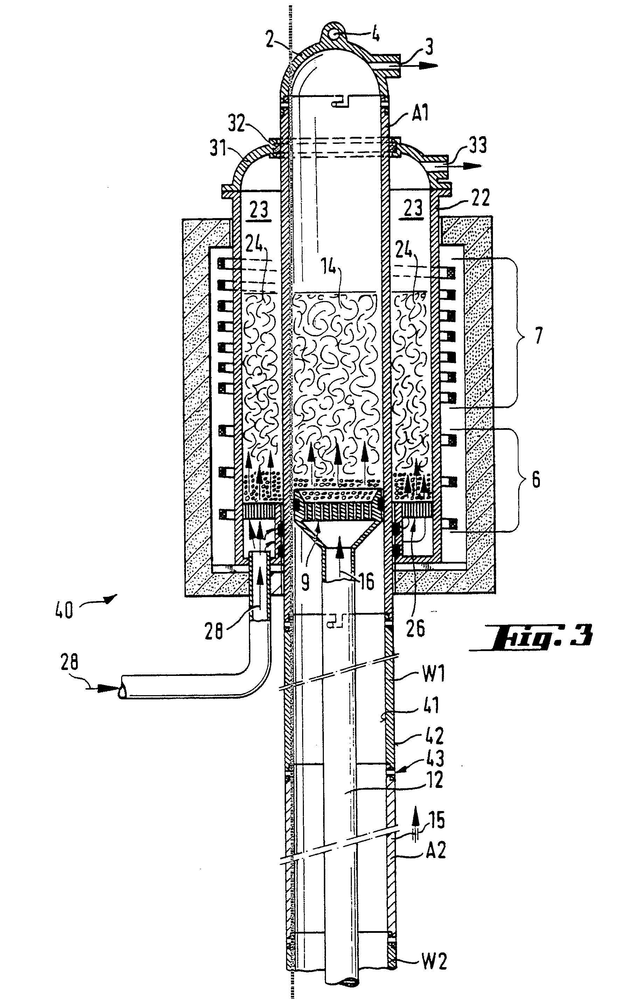

Die Figur 3 zeigt eine Kombination der Vorrichtungen nach den Figuren 1 und 2, wodurch ein Rohrofen 40 gebildet ist, welcher ein Fließbett 14 für die Innenwandbehandlung und ein Fließbett 24 für die Außenwandbehandlung aufweist.

Damit ist sowohl die Außenseite als auch die Innenseite der Werkstücke bearbeitbar.

Die Teile gleicher Bedeutung haben hier die gleichen Bezugszeichen wie die Figuren 1 und 2.

Lediglich die Verbindungen zwischen Werkstücken und Adaptern müssen hier ein wenig anders aussehen und so ausgebildet sein, daß die Innenwandung 41 und die Außenwandung 42 völlig glatt durchlaufend sind. Bei ausreichender Rohrwandstärke bietet sich auch hier eine bajonettartige Verbindung 43 an.

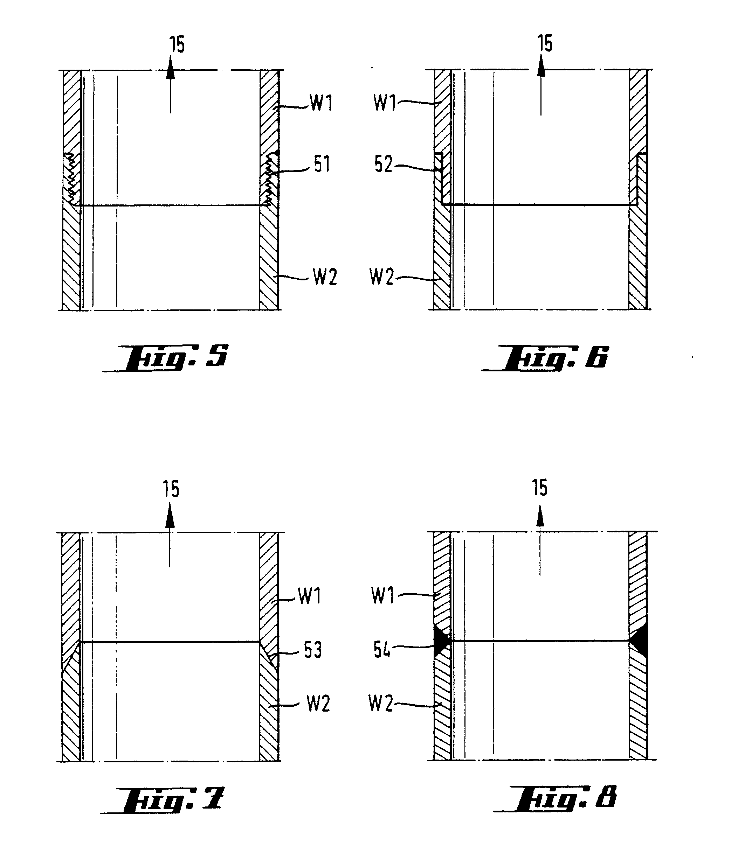

Wie die Figuren 5 - 8 zeigen, sind jedoch auch noch andere Verbindungsmöglichkeiten denkbar.

Nach Figur 5 können die Werkstücke bzw. die Adapter und die Werkstücke mit einem Gewinde 51 lösbar verbunden sein.

Nach Figur 6 kann auch eine zylindrische Schiebehaftverbindung 52 vorgesehen sein.

Nach Figur 7 kann eine konische, lose Verbindung vorgesehen sein, da ohnehin die Belastung des von unten nachgeführten Werkstückes bzw. Adapters ausreichen dürfte, die Verbindung zum Zwecke der Behandlung ausreichend aufrechtzuerhalten.

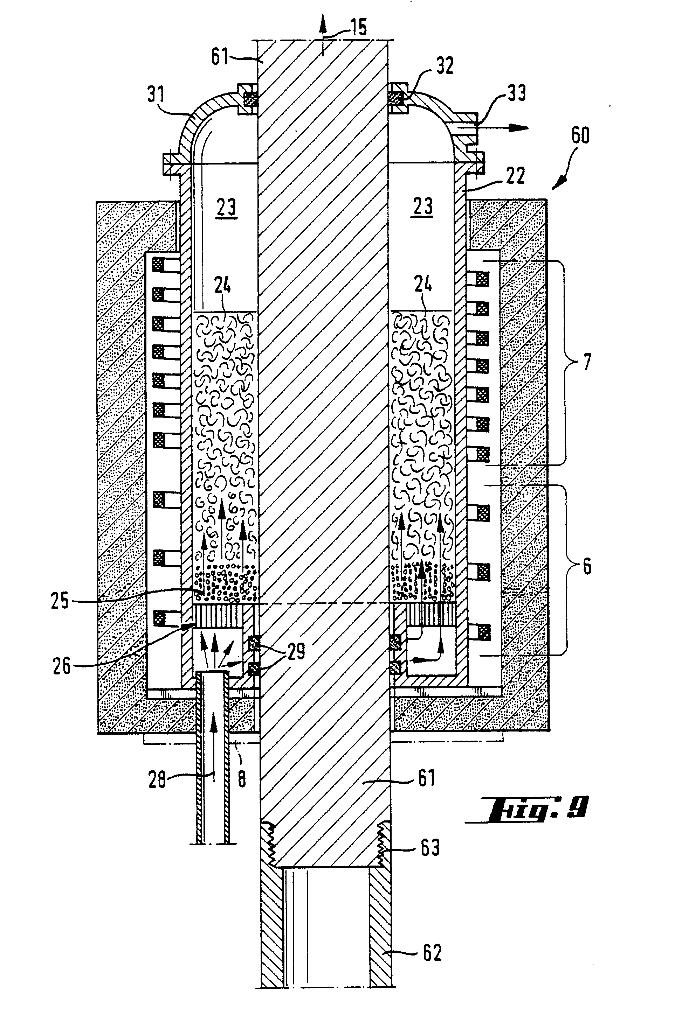

Ferner ist es gemäß Figur 8 möglich, die Werkstücke mit einem Rundschweißautomaten zu verschweißen (54) und nach der Behandlung entsprechend der gewünschten Länge wieder aufzutrennen.

In Figur 9 wird die Außenbehandlung massiver strangförmiger Körper 61 gezeigt. Die Anordnung ist die gleiche wie in Figur 2 für die Behandlung der Außenwandschicht von rohrförmigen Werkstücken. Die Verbindung 63 zum Adapter 62 ist beispielsweise eine Gewindeanordnung. Es kann sich hier auch um eine sonstige Schnellschlußverbindung handeln.

Der Adapter 62 muß nicht aus Vollmaterial bestehen und kann, wie gezeigt, auch ein Rohr sein (ähnlich dem Adapter A2 der Figur 2).

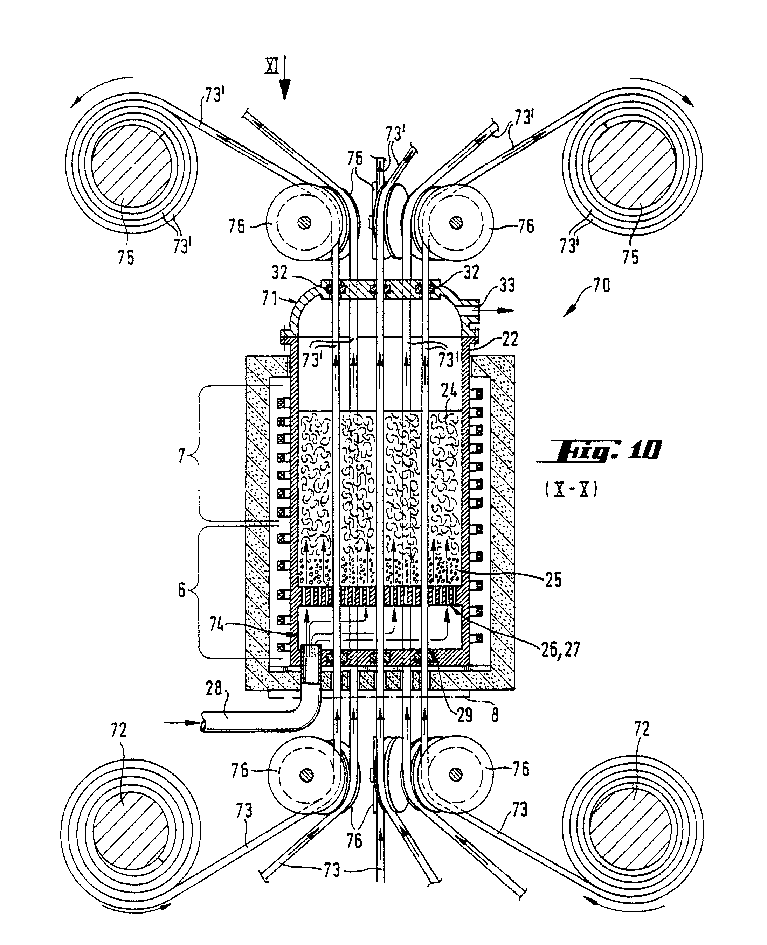

In Figur 10 wird ein Rohrofen 70 gezeigt, in dem dünnes drahtförmiges Material 73 boriert werden kann.

Das Material 73 wird von Spulen 72 abgewickelt, durchläuft über Umlenkrollen 76 eine Einfuhrglocke 74 mit mehreren entsprechenden Bohrungen und Dichtungen 29. Das drahtförmige Material 73 durchläuft in mehreren Strängen den Ofen 70 und tritt in behandelter Form 73' an der Abzugsglocke 71 aus, welche wiederum entsprechende Öffnungen mit entsprechenden Dichtungen 32 aufweist und wird entweder auf gewünschte Längen abgeschnitten oder, wie gezeigt, auf Spulen 75 aufgewickelt.

Gleiche Teile tragen die gleichen Bezugszeichen wie in den vorstehenden Figuren.

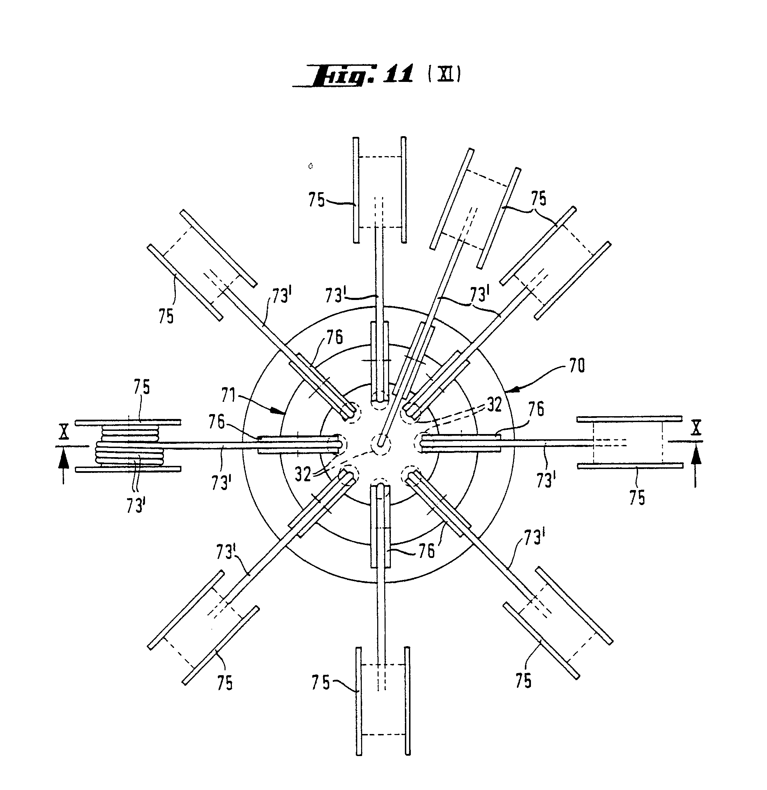

Die Figur 11 zeigt in Aufsicht zur Figur 10 ein Beispiel auf einen solchen Ring von Spulenkörpern 75 und Umlenkrollen 76.

Das Verfahren gemäß den in den Figuren 1 bis 3 gezeigten Ausführungsformen kann mit besonderem Vorteil zum Innen- und/außenborieren von

Rohren aus Eisenwerkstoffen, beispielsweise langen Hydraulikrohren mittels fester Boriergranulate in der Wirbelschicht auf Grundlage von borabgebenden Substanzen, wie Ferrobor oder Borcarbid, Verdünnungsmitteln, wie SiC und Aktivatoren, wie Kaliumfluorborat, verwendet werden.

**Patentansprüche**

1. Verfahren zum Borieren von Werkstücken aus Metallen oder Metallegierungen durch thermochemisches Behandeln mittels fester Boriermittel in der Wirbelschicht, die durch Verteilung eines Fluidisierungsgases in einem Reaktionsofen mit Hilfe eines Anströmbodens erzeugt wird, dadurch gekennzeichnet, daß lange rohr- oder strangförmige Werkstücke um mindestens einen ortsfesten Anströmboden herum oder durch Öffnungen in demselben geführt, mit ihrer zu borierenden Oberfläche senkrecht in Richtung der Längsachse des Ofens von unten nach oben durch die Wirbelschicht, die über mindestens einem ortsfesten Anströmboden erzeugt wird, bewegt und dabei boriert werden.

2. Verfahren nach Anspruch 1, dadurch gekennzeichnet, daß lange Rohre mit kreisförmigem, mehreckigem oder profiliertem Querschnitt um einen ortsfesten Anströmboden herum und/oder durch eine Öffnung in demselben geführt und mit ihrer zu borierenden Rohrinnen- und/oder Rohraußenoberfläche senkrecht in Richtung der Längsachse des Ofens von unten nach oben durch die Wirbelschicht transportiert werden.

3. Verfahren nach Anspruch 1, dadurch gekennzeichnet, daß lange massive Stäbe mit kreisförmigem, mehreckigem oder profiliertem Querschnitt durch mindestens eine Öffnung in einem ortsfesten Anströmboden geführt und mit ihrer zu borierenden Staboberfläche senkrecht in Richtung der Längsachse des Ofens von unten nach oben durch die Wirbelschicht transportiert werden.

4. Verfahren nach Anspruch 2 oder 3, dadurch gekennzeichnet, daß Adapter mit gleichem Durchmesser wie die Rohre oder Stäbe am oberen und am unteren Ende zur Führung der zu borierenden Rohre oder Stäbe verwendet werden.

5. Verfahren nach Anspruch 1, dadurch gekennzeichnet, daß lange dünne Drähte in mehreren Strängen durch dem Drahtdurchmesser entsprechende Bohrungen in einem ortsfesten Anströmboden geführt, mit ihrer zu borierenden Drahtoberfläche senkrecht in Richtung der Längsachse des Ofens von unten nach oben durch die Wirbelschicht bewegt und von Rolle zu Rolle verarbeitet werden.

## Claims

1. Process for boronising of workpieces made of metals or metal alloys by thermochemical treatment by means of solid boronising agents in a fluidised bed which is produced by distribution of a fluidising gas in a reaction furnace with the aid of an inlet plate, characterised in that long tubular or elongate workpieces are guided around at least one static inlet plate or through openings in the same, are moved with their surface to be boronised perpendicularly in the direction of the longitudinal axis of the furnace from the bottom upwards through the fluidised bed which is produced above at least one static inlet plate and are boronised in the process.

2. Process according to Claim 1, characterised in that long tubes of circular, polygonal or profiled cross-section are guided around a static inlet plate and/or through an opening in the same and, with their internal and/or external tube surfaces to be boronised, are transported perpendicularly in the direction of the longitudinal axis of the furnace from the bottom upwards through the fluidised bed.

3. Process according to Claim 1, characterised in that long solid bars of circular, polygonal or profiled cross-section are guided through at least one opening in a static inlet plate and, with their bar surface to be boronised, transported perpendicularly in the direction of the longitudinal axis of the furnace from the bottom upwards through the fluidised bed.

4. Process according to Claim 2 or 3, characterised in that adaptors of the same diameter as the tubes or bars at the upper and lower ends are used to guide the tubes or bars to be boronised.

5. Process according to Claim 1, characterised in that long thin wires in several strands are guided through holes corresponding to the diameter of the wire in a static inlet plate, are moved perpendicularly in the direction of the longitudinal axis of the furnace, with their wire surface to be boronised, from the bottom upwards through the fluidised bed and are processed from reel to reel.

## Revendications

1. Procédé pour borurer des pièces faites de métaux ou d'alliages métalliques, par traitement thermochimique à l'aide d'agents de boruration solides, dans un lit fluidisé, qui est produit en distribuant un gaz de fluidisation dans un four de réaction à l'aide d'un fond soufflant, caractérisé en ce qu'on fait passer des pièces de grande longueur, tubulaires ou en forme de barre, autour d'au moins un fond soufflant fixe, ou à travers des ouvertures de ce fond, qu'on fait défiler leur surface à borurer verticalement de bas en haut, selon l'axe longitudinal du four, à travers le lit fluidisé qui est engendré par au moins un fond soufflant fixe, et qu'on soumet ainsi cette surface à la boruration.

2. Procédé selon la revendication 1, caractérisé en ce qu'on fait passer des tubes de grande longueur, de section circulaire, polygonale ou profilée, autour d'un fond soufflant fixe et/ou à travers une ouverture de ce fond, et qu'on fait défiler la surface interne et/ou la surface externe du tube à borurer verticalement de bas en haut à travers le lit fluidisé, selon l'axe longitudinal du four.

3. Procédé selon la revendication 1, caractérisé en ce qu'on fait passer des barres massives de grande longueur, de section circulaire, polygonale ou profilée, à travers une ouverture d'un fond soufflant fixe et qu'on fait défiler leur surface à borurer verticalement de bas en haut à travers le lit fluidisé, selon l'axe longitudinal du four.

4. Procédé selon la revendication 2 ou 3, caractérisé en ce qu'on utilise des adaptateurs de même diamètre que les tubes ou barres à l'extrémité supérieure et à l'extrémité inférieure, pour le guidage des tubes ou barres à borurer.

5. Procédé selon la revendication 1, caractérisé en ce qu'on fait passer des fils minces de grande longueur en plusieurs brins à travers des trous percés à travers un fond soufflant fixe correspondant au diamètre du fil, en faisant défiler leur surface à borurer verticalement de bas en haut à travers le lit fluidisé, selon l'axe longitudinal du four, le traitement s'effectuant de bobine à bobine.

**Fig. 1**

*Fig. 2*

Fig. 3

Fig. 4

EP 0 259 825 B1

***Fig. 5***

***Fig. 6***

***Fig. 7***

***Fig. 8***

*Fig. 9*

**Fig. 10**

(X - X)

*Fig. 11* (XI)